# EUROPEAN PATENT APPLICATION

(11) **EP 4 822 283 A1**
(43) Date of publication of application: **14.10.2026**
(21) Application number: 24900239.5
(22) Date of filing: 03.09.2024
(51) Int. Cl.: F28F 13/08, F28D 15/00, F28D 15/02, H01L 23/473, H05K 7/20

(54) **HEAT TRANSFER SYSTEM**

(30) Priority: 04.12.2023 JP 2023204504
(71) Applicant: Sumitomo Electric Industries, Ltd., Osaka-shi, Osaka 541-0041 (JP)
(72) Inventor: MITANI, Atsuki, Osaka-shi, Osaka 541-0041 (JP); MAEDA, Toru, Osaka-shi, Osaka 541-0041 (JP)
(74) Representative: Boult Wade Tennant LLP
(86) International application number: PCT/JP2024/031563
(87) International publication number: WO 2025/120942

(57) **Abstract**

Provided is a heat transfer system for transferring heat generated in a heat source by using a fluid, the heat transfer system comprising: a flow passage wall defining a flow passage through which the fluid flows; and a metal porous body that is disposed in the flow passage and transfers heat generated in the heat source to the fluid flowing through the flow passage, wherein, in a cross-section of the flow passage perpendicular to a first direction from the upstream side to the downstream side in the flow passage provided with the metal porous body, when the cross-sectional area of the flow passage is defined as a first cross-sectional area S1, the cross-sectional area of the metal porous body is defined as a second cross-sectional area S2, and the area S1 - S2 obtained by subtracting the second cross-sectional area S2 from the first cross-sectional area S1 is defined as a third cross-sectional area S3, the flow passage includes a region in which the third cross-sectional area S3 decreases along the first direction, wherein the metal porous body is composed of a metal in which a plurality of pores are formed, wherein at least some of the pores among the plurality of pores are open pores, wherein the metal is composed of: a metal composed of a single metal element selected from a first group consisting of aluminum, magnesium, copper, silver, and gold; an alloy composed of two or more metal elements selected from the first group; a metal in a composite state of two or more metal elements selected from the first group; an alloy composed of one or more metal elements selected from the first group and one or more elements selected from a second group consisting of iron, cobalt, chromium, nickel, manganese, tin, zinc, silicon, phosphorus, carbon, boron, scandium, molybdenum, tungsten, and titanium; or a metal in a composite state of one or more metal elements selected from the first group and one or more elements selected from the second group, wherein the pore diameter of the pores in the metal porous body is 10 µm or more and 420 µm or less, wherein the porosity of the metal porous body is 60% or more and 85% or less, and wherein the permeability of the metal porous body is 0.6 × 10⁻¹² m² or more.

## Description

### TECHNICAL FIELD

The present disclosure relates to a heat transfer system. The present application claims priority to Japanese Patent Application No. 2023-204504 filed on December 4, 2023, which is incorporated herein by reference in its entirety.

### BACKGROUND ART

In a heat transfer system that utilizes a fluid as a heat transport medium, such as a heat exchanger, a boiler, an air conditioner, or a radiator, a heat exchange method in which heat is transferred from a high-temperature medium to a low-temperature medium via a heat transfer member having a high thermal conductivity in heat exchange between the high-temperature medium and the low-temperature medium has become common, and is used for various applications.

In order to improve heat exchange efficiency of a heat transfer system, a technique of providing a metal porous body as a heat transfer member in a flow passage for a fluid has been studied (for example, PTL 1).

### CITATION LIST

### PATENT LITERATURE

PTL 1: WO 2017/038380

### SUMMARY OF INVENTION

The heat transfer system of the present disclosure is a heat transfer system for transferring heat generated in a heat source by using a fluid, the heat transfer system comprising: a flow passage wall defining a flow passage through which the fluid flows; and a metal porous body that is disposed in the flow passage and transfers heat generated in the heat source to the fluid flowing through the flow passage, wherein, in a cross-section of the flow passage perpendicular to a first direction from the upstream side to the downstream side in the flow passage provided with the metal porous body, when the cross-sectional area of the flow passage is defined as a first cross-sectional area S1, the cross-sectional area of the metal porous body is defined as a second cross-sectional area S2, and the area S1 - S2 obtained by subtracting the second cross-sectional area S2 from the first cross-sectional area S1 is defined as a third cross-sectional area S3, the flow passage includes a region in which the third cross-sectional area S3 decreases along the first direction, wherein the metal porous body is composed of a metal in which a plurality of pores are formed, wherein at least some of the pores among the plurality of pores are open pores, wherein the metal is composed of: a metal composed of a single metal element selected from a first group consisting of aluminum, magnesium, copper, silver, and gold; an alloy composed of two or more metal elements selected from the first group; a metal in a composite state of two or more metal elements selected from the first group; an alloy composed of one or more metal elements selected from the first group and one or more elements selected from a second group consisting of iron, cobalt, chromium, nickel, manganese, tin, zinc, silicon, phosphorus, carbon, boron, scandium, molybdenum, tungsten, and titanium; or a metal in a composite state of one or more metal elements selected from the first group and one or more elements selected from the second group, wherein the pore diameter of the pores in the metal porous body is 10 µm or more and 420 µm or less, wherein the porosity of the metal porous body is 60% or more and 85% or less, and wherein the permeability of the metal porous body is 0.6 × 10⁻¹² m² or more.

### BRIEF DESCRIPTION OF DRAWINGS

[Fig. 1] Fig. 1 is a diagram illustrating a representative configuration example of a heat transfer system according to Embodiment 1.
[Fig. 2] Fig. 2 is a diagram showing a region provided with a metal porous body 4 of a heat transfer system 1 of Fig. 1, as viewed from above a heat source 8.
[Fig. 3] Fig. 3 is a cross-sectional view taken along line **III-III** in Fig. 2.
[Fig. 4] Fig. 4 is a cross-sectional view taken along line IV-IV in Fig. 2.
[Fig. 5] Fig. 5 is another example of the cross-sectional view taken along line IV-IV in Fig. 2.
[Fig. 6] Fig. 6 is another example of the cross-sectional view taken along line **III-III** in Fig. 2.
[Fig. 7] Fig. 7 is another example of the cross-sectional view taken along line IV-IV in Fig. 2.
[Fig. 8] Fig. 8 is a diagram illustrating a representative configuration example of a heat transfer system according to Embodiment 4.
[Fig. 9] Fig. 9 is a diagram showing a region provided with a metal porous body 4 of a heat transfer system 1 of Fig. 8, as viewed from above a heat source 8.
[Fig. 10] Fig. 10 is a diagram showing Fig. 9 as viewed from a rear side.
[Fig. 11] Fig. 11 is a cross-sectional view taken along line XI-XI in Fig. 9.
[Fig. 12] Fig. 12 is an example of a cross-sectional view taken along line XII-XII in Fig. 9.
[Fig. 13] Fig. 13 is another example of the cross-sectional view taken along line XII-XII in Fig. 9.
[Fig. 14] Fig. 14 is a diagram showing the structure inside a flow passage of Sample 2.
[Fig. 15] Fig. 15 is a diagram showing the structure inside a flow passage of Sample 3.
[Fig. 16] Fig. 16 is a diagram showing the structure inside a flow passage of Sample 4.
[Fig. 17] Fig. 17 is a diagram showing the structure inside a flow passage of Sample 2-1.

### DETAILED DESCRIPTION

### [Problem to be Solved by the Present Disclosure]

A heat transfer system using a metal porous body tends to experience a decrease in heat exchange efficiency associated with use of a heat exchanger. This tendency is particularly noticeable when industrial water containing a large amount of impurities or the like is used as a fluid. Therefore, a heat transfer system that has excellent heat exchange efficiency and in which a decrease in heat exchange efficiency associated with use is suppressed is desired.

Therefore, an object of the present disclosure is to provide a heat transfer system that has excellent heat exchange efficiency and in which a decrease in heat exchange efficiency associated with use is suppressed.

### [Advantageous Effect of the Present Disclosure]

According to the present disclosure, there can be provided a heat transfer system that has excellent heat exchange efficiency and in which a decrease in heat exchange efficiency associated with use is suppressed.

### [Description of Embodiments]

First, embodiments of the present disclosure will be listed and described.
(1) The heat transfer system of the present disclosure is a heat transfer system for transferring heat generated in a heat source by using a fluid, the heat transfer system comprising: a flow passage wall defining a flow passage through which the fluid flows; and a metal porous body that is disposed in the flow passage and transfers heat generated in the heat source to the fluid flowing through the flow passage, wherein, in a cross-section of the flow passage perpendicular to a first direction from the upstream side to the downstream side in the flow passage provided with the metal porous body, when the cross-sectional area of the flow passage is defined as a first cross-sectional area S1, the cross-sectional area of the metal porous body is defined as a second cross-sectional area S2, and the area S1 - S2 obtained by subtracting the second cross-sectional area S2 from the first cross-sectional area S1 is defined as a third cross-sectional area S3, the flow passage includes a region in which the third cross-sectional area S3 decreases along the first direction, wherein the metal porous body is composed of a metal in which a plurality of pores are formed, wherein at least some of the pores among the plurality of pores are open pores, wherein the metal is composed of: a metal composed of a single metal element selected from a first group consisting of aluminum, magnesium, copper, silver, and gold; an alloy composed of two or more metal elements selected from the first group; a metal in a composite state of two or more metal elements selected from the first group; an alloy composed of one or more metal elements selected from the first group and one or more elements selected from a second group consisting of iron, cobalt, chromium, nickel, manganese, tin, zinc, silicon, phosphorus, carbon, boron, scandium, molybdenum, tungsten, and titanium; or a metal in a composite state of one or more metal elements selected from the first group and one or more elements selected from the second group, wherein the pore diameter of the pores in the metal porous body is 10 µm or more and 420 µm or less, wherein the porosity of the metal porous body is 60% or more and 85% or less, and wherein the permeability of the metal porous body is 0.6 × 10⁻¹² m² or more.
   According to the present disclosure, there can be provided a heat transfer system that has excellent heat exchange efficiency and in which a decrease in heat exchange efficiency associated with use is suppressed.
(2) In the above (1), a length L3 of the region in which the third cross-sectional area S3 decreases along the first direction may be 30% or more of a length L1 of the metal porous body along the first direction. According to this, a decrease in heat exchange efficiency associated with use of the heat transfer system is further suppressed.
(3) In the above (1) or (2), the flow passage wall may include a flow passage cross-sectional area adjusting member that is disposed in the flow passage and configured to decrease the third cross-sectional area S3. According to this, by adjusting the shape or disposition of the flow passage cross-sectional area adjusting member, adjustment of the region in which the third cross-sectional area S3 decreases becomes easy.
(4) In the above (1) or (2), the metal porous body may include a main body portion extending along the first direction, a first end face on the upstream side of the flow passage in the main body portion, and a second end face on the downstream side of the flow passage in the main body portion, and in the metal porous body, a through-hole penetrating from the first end face to the second end face may be formed separately from the plurality of pores.
   According to this, by promoting suction of the fluid into the metal porous body through the wall surface of the through-hole, improvement in heat exchange efficiency can be expected. Foreign matter or the like contained in the fluid can pass through the through-hole, thereby suppressing intrusion into the metal porous body and occurrence of clogging.
(5) In the above (4), in a cross-section of the metal porous body perpendicular to the first direction, when the cross-sectional area of the through-hole is defined as a fourth cross-sectional area S4, the metal porous body may include a region in which the fourth cross-sectional area S4 decreases along the first direction, and in a cross-section of the flow passage provided with the metal porous body and perpendicular to the first direction, all outer edges of the metal porous body may be in contact with the flow passage wall.
   According to this, by slowing the moving speed of the fluid on an inner wall surface of the through-hole, suction of the fluid into the metal porous body is promoted, and improvement in heat exchange efficiency is expected. On the other hand, the flow velocity at a central portion of the through-hole is improved, thereby maintaining the effect of discharging foreign matter.
(6) In any of the above (1) to (5), the metal porous body may include a main body portion extending along the first direction, a first end face on an upstream side of the flow passage in the main body portion, and a second end face on a downstream side of the flow passage in the main body portion, and the heat transfer system may comprise a shielding member provided on the first end face.
   According to this, in the heat transfer system, a decrease in heat exchange efficiency associated with use is further suppressed.
(7) In any of the above (1) to (6), the thermal conductivity of the metal may be 100 W/m·K or more. According to this, the heat exchange efficiency of the heat transfer system is further improved.
(8) In any of the above (1) to (7), the permeability of the metal porous body may be 0.8 × 10⁻¹² m² or more. According to this, the heat exchange efficiency of the heat transfer system is further improved.
(9) **In** any of the above (1) to (8), the open porosity of the pores in the metal porous body may be 60% or more. According to this, the flow resistance of the fluid is reduced.
(10) The heat transfer system of the present disclosure is a heat transfer system for transferring heat generated in a heat source by using a fluid, the heat transfer system comprising: a flow passage wall defining a flow passage through which the fluid flows; and a metal porous body that is disposed in the flow passage and transfers heat generated in the heat source to the fluid flowing through the flow passage, wherein, when viewed along a first direction from the upstream side to the downstream side of the flow passage provided with the metal porous body, the metal porous body includes a first region having a first width and positioned on a heat source side, and a second region that is provided on a side opposite to the heat source with the first region interposed therebetween and has a width narrower than the first width, wherein the flow passage is occupied by the first region and the second region, wherein the metal porous body is composed of a metal in which a plurality of pores are formed, wherein at least some of the pores among the plurality of pores are open pores, wherein the metal is composed of: a metal composed of a single metal element selected from a first group consisting of aluminum, magnesium, copper, silver, and gold; an alloy composed of two or more metal elements selected from the first group; a metal in a composite state of two or more metal elements selected from the first group; an alloy composed of one or more metal elements selected from the first group and one or more elements selected from a second group consisting of iron, cobalt, chromium, nickel, manganese, tin, zinc, silicon, phosphorus, carbon, boron, scandium, molybdenum, tungsten, and titanium; or a metal in a composite state of one or more metal elements selected from the first group and one or more elements selected from the second group, wherein the pore diameter of the pores in the metal porous body is 10 µm or more and 420 µm or less, wherein the porosity of the metal porous body is 60% or more and 85% or less, and wherein the permeability of the metal porous body is 0.6 × 10⁻¹² m² or more.

According to the present disclosure, there can be provided a heat transfer system that has excellent heat exchange efficiency and in which a decrease in heat exchange efficiency associated with use is suppressed.

### [Details of Embodiments of the Present Disclosure]

Hereinafter, specific examples of the heat transfer system of the present disclosure will be described with reference to drawings. In the drawings of the present disclosure, the same reference signs represent the same portions or equivalent portions. In addition, dimensional relationships such as length, width, thickness, and depth are changed as appropriate for clarity and simplicity in the drawings and do not necessarily represent actual dimensional relationships.

In the present specification, the expression "A to B" represents a range of lower to upper limits (i.e., A or more and B or less), and in the case where no unit is indicated for A and a unit is indicated only for B, the unit of A is the same as the unit of B.

In the case where a compound or the like is expressed by a chemical formula in the present specification and an atomic ratio is not particularly limited, it is assumed that all the conventionally known atomic ratios are included, and the atomic ratio is not necessarily limited only to one in the stoichiometric range.

In the present disclosure, in the case where one or more numerical values are provided as a lower limit and an upper limit of a numerical range, it is considered that combinations of any one of the numerical values set forth as the lower limit and any one of the numerical values set forth as the upper limit are also disclosed.

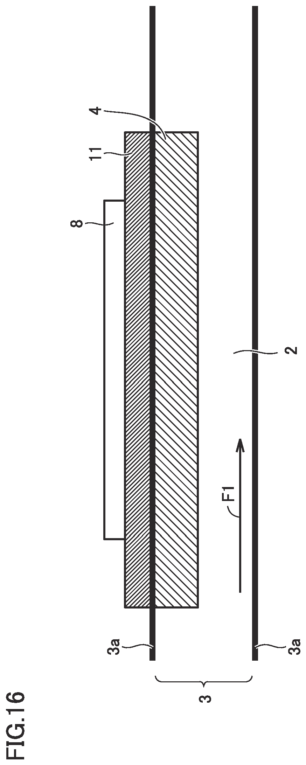

The present inventors examined reasons why a decrease in heat exchange efficiency occurs in a conventional heat transfer system in developing a heat transfer system that has excellent heat exchange efficiency and in which a decrease in heat exchange efficiency associated with use is suppressed. In a conventional heat transfer system, for example, as shown in Fig. 16, a flow passage 3 is occupied by a metal porous body 4. When metal porous body 4 was observed after a heat transfer system having the configuration shown in Fig. 16 was used for a certain period of time, it was confirmed that impurities contained in a fluid 2 adhered to pores in metal porous body 4, causing clogging. It was presumed that clogging makes it easy for heat transfer from metal porous body 4 to fluid 2 to be hindered, resulting in a decrease in heat exchange efficiency.

Based on the above presumption, the present inventors assumed that a decrease in heat exchange efficiency could be suppressed by suppressing clogging of metal porous body 4, and as a result of trial and error, completed the heat transfer system of the present disclosure. Specific examples of the heat transfer system of the present disclosure will be described below.

### [Embodiment 1]

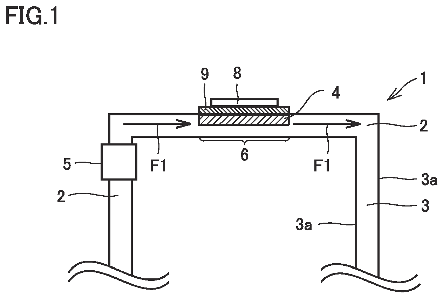

The configuration of a heat transfer system in one embodiment of the present disclosure (hereinafter, also referred to as "Embodiment 1") will be described with reference to Fig. 1 to Fig. 4. As shown in Fig. 1, a heat transfer system 1 of Embodiment 1 includes a flow passage wall 3a defining a flow passage 3 through which a fluid 2 flows, and a metal porous body 4 that is disposed in flow passage 3 and transfers heat generated in a heat source 8 to fluid 2 flowing through flow passage 3.

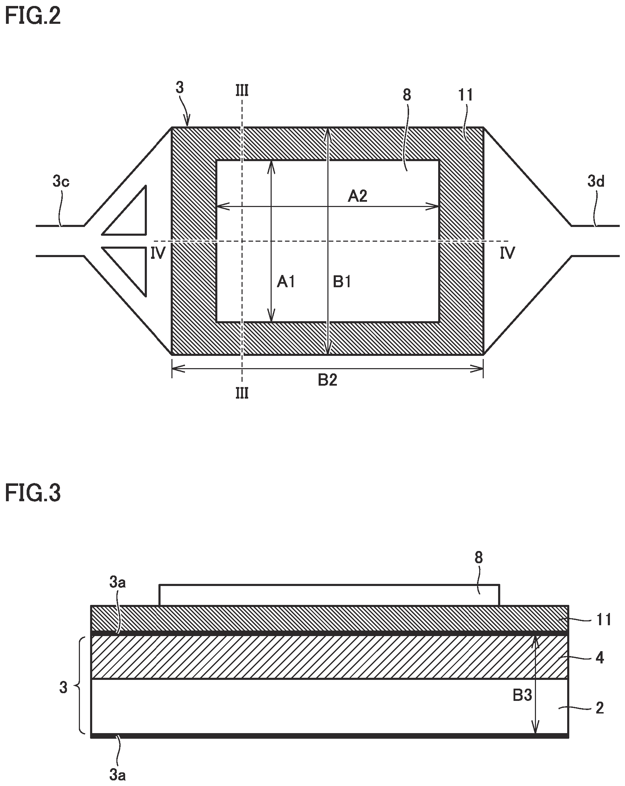

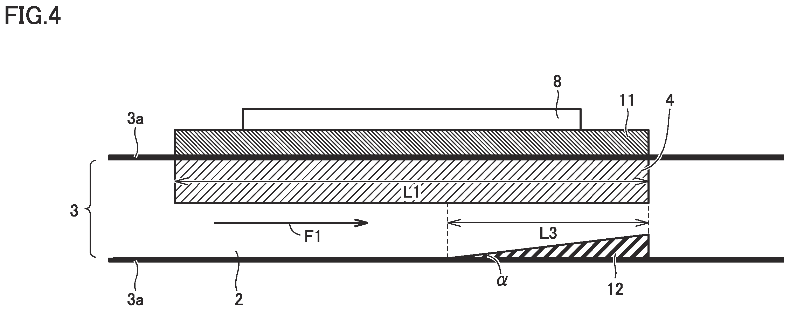

Fig. 2 is a diagram showing a region provided with metal porous body 4 of heat transfer system 1 of Fig. 1, as viewed from above heat source 8. Fig. 3 is a cross-sectional view taken along line III-III in Fig. 2. Fig. 4 is a cross-sectional view taken along line IV-IV in Fig. 2. In Fig. 4, a direction of the arrow F1 corresponds to the first direction from the upstream side to the downstream side of the flow passage.

In the flow passage provided with metal porous body 4, metal porous body 4 is provided on flow passage wall 3a positioned on a heat source 8 side. As a result, heat generated in heat source 8 is easily transferred to metal porous body 4. When a driving force in an arrow F1 direction is applied to fluid 2 to allow it to pass through metal porous body 4, heat exchange is carried out between fluid 2 and heat source 8 via metal porous body 4. Heat transfer system 1 can include a metal plate 11 that is disposed between heat source 8 and flow passage wall 3a and promotes transfer of heat from heat source 8 to fluid 2.

The thermal conductivity of the metal porous body used in Embodiment 1 is higher than the thermal conductivity of a general fluid used in a heat transfer system (for example, water, radiator fluid, or industrial water). Therefore, in flow passage 3 provided with metal porous body 4, heat from heat source 8 is easily transferred to fluid 2 through metal porous body 4. That is, the presence of metal porous body 4 improves the efficiency of heat exchange between fluid 2 and heat source 8.

On the other hand, when metal porous body 4 is provided in flow passage 3, metal porous body 4 increases the movement resistance (pressure loss) of fluid 2, and the flow velocity of fluid 2 in the arrow F1 direction after passing through metal porous body 4 tends to decrease. When the flow velocity in the arrow F1 direction decreases, the heat exchange efficiency between fluid 2 and heat source 8 decreases. Since metal porous body 4 used in Embodiment 1 has a high permeability, the effect of an increase in heat transfer amount due to a large specific surface area (a positive effect on heat exchange efficiency) becomes greater than the effect of a decrease in flow velocity due to an increase in movement resistance (a negative effect on heat exchange efficiency), thereby making it possible to improve heat exchange efficiency. For this reason, the effect of a decrease in flow velocity caused by providing metal porous body 4 is suppressed. Therefore, by using metal porous body 4 of Embodiment 1, the heat exchange efficiency between fluid 2 and heat source 8 is improved as a whole.

As shown in Fig. 4, in flow passage 3, a flow passage cross-sectional area adjusting member 12 is provided on flow passage wall 3a at a location where metal porous body 4 is provided, and in a cross-section perpendicular to the first direction from the upstream side to the downstream side in flow passage 3 provided with metal porous body 4, when the cross-sectional area of flow passage 3 is defined as a first cross-sectional area S1, the cross-sectional area of metal porous body 4 is defined as a second cross-sectional area S2, and the area S1 - S2 obtained by subtracting the second cross-sectional area S2 from the first cross-sectional area S1 is defined as a third cross-sectional area S3, flow passage 3 includes a region in which the third cross-sectional area S3 decreases along the first direction. According to this, in the region in which the third cross-sectional area S3 of the flow passage decreases, the flow velocity of the fluid increases. When the flow velocity of the fluid increases, a force directed toward the outside of the metal porous body is applied to the fluid that has entered pores in the metal porous body, and the fluid is likely to move to the outside of the metal porous body. With movement of the fluid, impurities contained in the fluid also move to the outside of the metal porous body, and therefore, adhesion of impurities to the pores in the metal porous body is suppressed, and clogging of the metal porous body is suppressed. Thus, in the heat transfer system of Embodiment 1, heat exchange efficiency associated with use is suppressed.

A length L3 of the region in which the third cross-sectional area S3 decreases along the first direction may be 30% or more of a length L1 of the metal porous body along the first direction. According to this, the flow velocity of the fluid is more likely to increase, the effect of preventing clogging of the metal porous body is improved, and in the heat transfer system, heat exchange efficiency associated with use is further suppressed. The percentage of the length L3 to the length L1 may be 30% or more and 100% or less, may be 40% or more and 100% or less, or may be 60% or more and 100% or less. The percentage of the length L3 to the length L1 being 100% means that the region in which the third cross-sectional area S3 decreases is positioned from the upstream side to the downstream side of the flow passage provided with metal porous body 4.

As shown in Fig. 4, the third cross-sectional area S3 may be smallest on the downstream side of flow passage 3 provided with metal porous body 4. The downstream side of the flow passage provided with the metal porous body means a region sandwiched between the center of the width of the flow passage when viewed along the first direction and the downstream-side end portion of the flow passage.

In the region in which the third cross-sectional area S3 decreases, the percentage of the third cross-sectional area S3 to the first cross-sectional area S 1, (S3/S 1) × 100, may be 0% or more and 90% or less, or may be 8% or more and 50% or less.

In the region in which the third cross-sectional area S3 decreases, the difference between the maximum value and the minimum value of the percentage (S3/S 1) × 100 may be 8% or more and 90% or less.

In a region other than the region in which the third cross-sectional area S3 decreases in the flow passage provided with the metal porous body, the percentage of the third cross-sectional area S3 to the first cross-sectional area S1, (S3/S1) × 100, may be 0% or more and 90% or less.

### <Flow Passage>

In heat transfer system 1 of Embodiment 1, flow passage 3 is defined by flow passage wall 3a. Flow passage 3 may form at least one closed loop. The closed loop may have a branch within one closed loop. Alternatively, flow passage 3 may form a plurality of closed loops disposed in parallel. When flow passage 3 forms a closed loop, fluid 2 circulates within flow passage 3.

There is no particular limitation on the shape of the cross-section of flow passage 3 in a cross-section perpendicular to the first direction from the upstream side to the downstream side of the flow passage. For example, the shape of the cross-section of flow passage 3 may be rectangular, circular, or elliptical. There is no particular limitation on the area of the cross-section, and it may be changed as appropriate depending on the application.

Flow passage wall 3a may have an opening that connects flow passage 3 and an external space of flow passage 3. In this case, fluid 2 can move between flow passage 3 and the external space.

There is no particular limitation on the shape of flow passage wall 3a, and a conventionally known shape can be used.

The material of flow passage wall 3a can be selected as appropriate in consideration of resistance to the fluid, thermal conductivity, heat insulation, and other factors. For example, a fluororesin such as polytetrafluoroethylene can be used. Of flow passage wall 3a, the material of the flow passage wall positioned in the region provided with the metal porous body may be a material having higher thermal conductivity than other portions (for example, aluminum, copper, stainless steel, or aluminum oxide). Alternatively, the flow passage wall positioned in the region provided with the metal porous body may be covered with a material different from that of the flow passage wall (for example, aluminum, copper, or stainless steel).

Flow passage wall 3a and metal porous body 4 may be in contact with each other. According to this, the amount of heat transferred from metal porous body 4 to fluid 2 increases, the flow velocity of the fluid further improves, the overall generated flow of the heat transfer system further improves, and heat exchange efficiency further improves. Flow passage wall 3a and metal porous body 4 may be integrally formed or may be joined by soldering. As long as the effects of the present disclosure are not impaired, configurations in which flow passage wall 3a and metal porous body 4 are not in contact are also included within the scope of the present disclosure. Examples of such configurations include cases where a very small gap exists between flow passage wall 3a and metal porous body 4, and cases where another member having very high thermal conductivity is interposed between flow passage wall 3a and metal porous body 4.

### <Metal Porous Body>

In heat transfer system 1 of Embodiment 1, metal porous body 4 is composed of a metal in which a plurality of pores are formed. At least some of the pores among the plurality of pores are open pores. The open pores refer to those included in metal porous body 4 that are in communication with the surface of metal porous body 4. Since metal porous body 4 has open pores, the fluid can move between the outside of metal porous body 4 and the inside of metal porous body 4 through the open pores. Among the plurality of pores, at least some of the pores are in communication with each other. Of the outer peripheral surface of metal porous body 4 present in the region in which the third cross-sectional area S3 decreases, regions not in contact with flow passage wall 3a are exposed, and no member exists that blocks the open pores. According to this, the fluid that has entered the pores in metal porous body 4 can easily move to the outside of metal porous body 4.

### <<Compositional Features>>

The metal constituting metal porous body 4 is composed of: a metal composed of a single metal element selected from a first group consisting of aluminum, magnesium, copper, silver, and gold; an alloy composed of two or more metal elements selected from the first group; a metal in a composite state of two or more metal elements selected from the first group; an alloy composed of one or more metal elements selected from the first group and one or more elements selected from a second group consisting of iron, cobalt, chromium, nickel, manganese, tin, zinc, silicon, phosphorus, carbon, boron, scandium, molybdenum, tungsten, and titanium; or a metal in a composite state of one or more metal elements selected from the first group and one or more elements selected from the second group.

Since the above-described metal has high thermal conductivity, the heat exchange efficiency of the heat transfer system is further improved.

In the present disclosure, the term "metal" is defined as a concept including a metal composed of a single metal element, an alloy containing two or more metal elements, and a metal in a composite state of two or more metal elements.

In the present disclosure, the expression "metal in a composite state of two or more metal elements" means a state in which each of two or more metals exists as a separate substance rather than as an alloy. Specifically, it refers to a state in which the surfaces of two or more metal powders are bonded together and molded.

In the present disclosure, the expression "metal in a composite state of one or more metal elements selected from the first group and one or more elements selected from the second group" may be a state in which, when the element from the second group is carbon, one or more metal powders selected from the first group are bonded with graphite or diamond, or may be a carbide of one or more metals selected from the first group. Alternatively, when the element from the second group is boron, it may be a state in which one or more metal powders selected from the first group are bonded with powder of boron simple substance, or may be a boride of one or more metals selected from the first group.

Examples of the alloy include Cu-1%Ag alloy and Al-1%Mg-0.6%Si-0.5%Fe-0.25%Cu-0.1%Cr alloy (A6061).

From the viewpoint of having high thermal conductivity, the metal may be pure copper, pure aluminum, a copper alloy containing 50% by mass or more of copper, or an aluminum alloy containing 50% by mass or more of aluminum. The alloy may be in a state in which the constituent elements are solid-solved in copper, aluminum, or the like. The alloy may also be in a state in which precipitates or different phases are present in a dispersed manner.

The compositional features of the constituent elements of the metal porous body are measured by ICP emission spectroscopy.

The metal porous body of the heat transfer system of Embodiment 1 may contain impurities other than the above-described metal to the extent that the effects of the present disclosure are not impaired. Here, the term "metal" is, as defined above, a concept including a metal composed of a single metal element, an alloy containing two or more metal elements, and a metal in a composite state of two or more metal elements. The metal porous body of Embodiment 1 can be composed of the above-described metal and impurities. Examples of such impurities include oxygen, hydrogen, carbon, nitrogen, sulfur, phosphorus, boron, and silicon, as well as metal elements other than the metal elements included in the first group and second group described above. The impurities are contained independently from the matrix, for example in the form of precipitates. The content ratio of the impurities may be any value as long as it is less than the volume ratio that satisfies a predetermined thermal conductivity. For example, it can be 3 atom% or less. The content ratio of the impurities is measured by gas chromatography (GC) analysis or ICP emission spectroscopy.

### <<Structure>>

Metal porous body 4 is composed of a metal in which a plurality of pores are formed. That is, metal porous body 4 has a plurality of pores. At least some of the pores are open pores. The pore diameter of the pores in the metal porous body is 10 µm or more and 420 µm or less. The porosity of metal porous body 4 is 60% or more and 85% or less. The permeability of metal porous body 4 is 0.6 × 10⁻¹² m² or more. According to this, the fluid can pass through the inside of the metal porous body via the pores in the metal porous body.

The metal porous body may include a main body portion extending along the first direction, a first end face on the upstream side of the flow passage in the main body portion, and a second end face on the downstream side of the flow passage in the main body portion, and a shielding member may be provided on the first end face. The shielding member may be provided so as to cover the entire first end face or so as to cover a part of the first end face.

### <<Pore Diameter of Pores>>

In Embodiment 1, the pore diameter of the pores in the metal porous body is 10 µm or more and 420 µm or less. When the pore diameter of the pores in the metal porous body is 10 µm or more, an increase in the flow resistance of the fluid is suppressed. When the minimum pore diameter of the pores is less than 10 µm, movement of the fluid due to capillary force is less likely to occur, and therefore, even in open pores, portions far from the shortest path of the fluid movement path substantially act as closed pores. When the pore diameter of the pores in the metal porous body is 420 µm or less, the contact area with the fluid increases, and heat transfer between the metal porous body and the fluid can be promoted.

The pore diameter of the pores in the metal porous body may be 15 µm or more and 420 µm or less, may be 20 µm or more and 380 µm or less, may be 30 µm or more and 360 µm or less, or may be 40 µm or more and 300 µm or less.

The pore diameter of the pores in the metal porous body is measured by a mercury intrusion method. The mercury intrusion method is carried out in accordance with JIS R 1655:2003, "Test methods for pore size distribution of fine ceramic green body by mercury porosimetry". As the apparatus, AutoPore V9600 manufactured by Micrometritics Instrument Corporation can be used. In the present disclosure, the pore diameter of the pores in the metal porous body means the range of pore diameter distribution of the open pores in the metal porous body measured by the mercury intrusion method. For example, the pore diameter of the pores in the metal porous body being 10 µm or more and 420 µm or less means that the pore diameter of each open pore in the metal porous body is within the range of 10 µm or more and 420 µm or less.

### <<Porosity>>

In Embodiment 1, the porosity of metal porous body 4 is 60% or more and 85% or less. The lower limit of the porosity of the metal porous body is 60% or more from the viewpoint of reducing the flow resistance of the fluid. The upper limit of the porosity of the metal porous body is 85% or less from the viewpoint of increasing the contact area with the fluid and promoting heat transfer between the metal porous body and the fluid. The porosity of the metal porous body may be 70% or more and 85% or less, or may be 75% or more and 80% or less.

The porosity of the metal porous body is defined by the following expression (1). 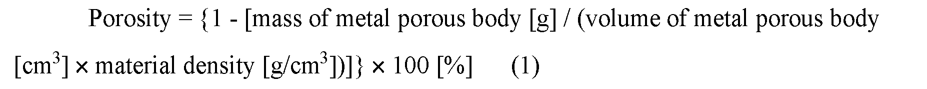 Porosity = {1 - [mass of metal porous body [g] / (volume of metal porous body [cm3] × material density [g/cm3])]} × 100 [%] (1)

In the above expression (1), the "volume of metal porous body [cm³]" means the volume based on the outer shape of the metal porous body including the pores.

### <<Permeability>>

In Embodiment 1, the permeability of the metal porous body is 0.6 × 10⁻¹² m² or more. According to this, the flow resistance of the fluid is reduced. The permeability of the metal porous body may be 0.60 × 10⁻¹² m² or more and 1.0 × 10⁻¹⁰ m² or less, may be 0.70 × 10⁻¹² m² or more and 1.0 × 10⁻¹⁰ m² or less, may be 0.80 × 10⁻¹² m² or more and 1.0 × 10⁻¹⁰ m² or less, or may be 0.90 × 10⁻¹² m² or more and 1.0 × 10⁻¹⁰ m² or less.

The measurement of the permeability of the metal porous body can be carried out by evaluating the water permeability of the metal porous body in accordance with JIS R 1671:2006, "Testing method for water permeability and hydraulic equivalent diameter of porous fine ceramics". Specifically, an evaluation sample composed of a metal porous body with a diameter of 25 mm and a thickness of 3 mm is prepared, and the evaluation is conducted based on the above JIS standard. When the metal porous body to be evaluated is smaller than the size of the above-described evaluation sample, an evaluation sample may be prepared by combining a plurality of metal porous bodies so as to achieve a diameter of 25 mm and a thickness of 3 mm.

### <<Open Porosity>>

In heat transfer system 1 of Embodiment 1, metal porous body 4 includes open pores. In the present disclosure, the term "open porosity" means a volume ratio (% by volume) of open pores with respect to all pores (including open pores and closed pores) included in the metal porous body. The term "open pores" refers to those included in the metal porous body that are in communication with the surface of the metal porous body. The term "closed pores" refers to those included in the metal porous body that are not in communication with the surface of the metal porous body.

In Embodiment 1, the open porosity of the pores in the metal porous body may be 50% or more from the viewpoint of reducing the flow resistance of the fluid. The open porosity of the pores may be 50% or more and 100% or less, may be 60% or more and 100% or less, or may be 70% or more and 100% or less.

The method for measuring the open porosity of the pores in the metal porous body is as follows. First, an apparent porosity P1 (corresponding to the open porosity of the metal porous body) is measured by an Archimedes method or a mercury intrusion method (specified in JIS R 1655:2003, "Test methods for pore size distribution of fine ceramic green body by mercury porosimetry").

Based on the above expression (1), a porosity P2 of the metal porous body (corresponding to the total porosity of the metal porous body) is calculated.

The value of the percentage of the apparent porosity P1 of the metal porous body described above to the porosity P2 of the metal porous body described above, (P1/P2) × 100, is calculated. The percentage is the open porosity of the pores in the metal porous body.

### <<Thermal Conductivity of Metal Porous Body>>

In Embodiment 1, the thermal conductivity of the metal porous body may be 10 W/m·K or more. According to this, heat from the outside of the internal space is easily transferred to the fluid through the metal porous body. The thermal conductivity of the metal porous body may be 10 W/m·K or more and 205 W/m·K or less, may be 15 W/m·K or more and 205 W/m·K or less, or may be 25 W/m·K or more and 205 W/m·K or less.

The method for measuring the thermal conductivity of the metal porous body is as follows. Upper and lower surfaces (circular portions) of a metal porous body processed to φ10 mm × 2.2 mmt are polished by 0.1 mm using emery paper in a non-oxidizing room temperature atmosphere with an oxygen concentration of 10000 ppm, thereby setting the thickness to 2.0 mm. After removing grinding debris by air blowing or the like, a pure aluminum foil of φ10 mm × 20 µm in thickness is brought into contact with the polished upper and lower surfaces of the metal porous body. In this state, a load of 50 kgf is applied using a hand press to bring the aluminum foil into close contact with the metal porous body, thereby obtaining a sample for measurement.

Using the above-described sample for measurement, the thermal conductivity of the metal porous body is measured by a laser flash method. More specifically, while measuring the thermal diffusion coefficient using LFA 457 MicroFlash (manufactured by NETZSCH), based on the thermal diffusion coefficient as well as the volume ratios and specific heat capacities of the respective constituent materials, the thermal conductivity of the metal porous body in the thickness direction is calculated.

Upon the above-described calculation of thermal conductivity, the specific heat capacities of the respective constituent materials are determined based on "Metal Data Book, 4th Edition" edited by the Japan Institute of Metals (2004, Maruzen Publishing). The pores can be treated as air, and the specific heat capacity thereof is calculated as 1.0 kJ/(kg·K). In addition, prior to the measurement of thermal conductivity, the thermal conductivity of a pure copper sample having the same shape is measured under the same conditions, and the result thereof is used as a reference to correct the measurement result.

When the planar shape of the metal porous body to be evaluated is smaller than a circular shape having a diameter of 10 mm, evaluation may be performed by cutting out a plurality of samples and arranging them so that their surfaces lie on the same plane, thereby securing a measurement area of 50 mm² or more.

### <<Thermal Conductivity of Metal>>

In the metal porous body of the heat transfer system of Embodiment 1, the thermal conductivity of the metal may be 100 W/m·K or more. Examples of factors involved in the thermal conductivity of the metal porous body include the thermal conductivity of the material, the volume ratio of the metal in the metal porous body, and, when the metal porous body is formed by bonding metal powders, interfacial thermal resistance between the metal powders. When the thermal conductivity of the metal is 100 W/m·K or more, the thermal conductivity of the metal porous body is improved.

The thermal conductivity of the above-described metal may be 100 W/m·K or more and 400 W/m·K or less, may be 200 W/m·K or more and 400 W/m·K or less, or may be 350 W/m·K and 400 W/m·K or less.

The method for measuring the thermal conductivity of the metal is as follows. The metal porous body is heated, in a hydrogen atmosphere, at a temperature (K) corresponding to 80% of the lowest melting temperature (K) among the constituent materials so that no oxide film of the metal serving as the base material is present on the inner walls of the metal porous body, and thereafter, while maintaining a non-oxidizing atmosphere, the metal porous body is densified by a spark plasma sintering method in a vacuum (10 Pa or less). The heating temperature at this time is set to the above-described hydrogen atmosphere treatment temperature, the applied pressure is 30 MPa, and the pressurization time is 10 minutes. The thermal conductivity of the obtained dense body is measured by a laser flash method. More specifically, while measuring the thermal diffusion coefficient using LFA 457 MicroFlash (manufactured by NETZSCH), based on the thermal diffusion coefficient as well as the volume ratios and specific heat capacities of the respective constituent materials, the thermal conductivity in the thickness direction is calculated.

Upon the above-described calculation of thermal conductivity, the specific heat capacities of the respective constituent materials are determined based on "Metal Data Book, 4th Edition" edited by the Japan Institute of Metals (2004, Maruzen Publishing). The pores can be treated as air, and the specific heat capacity thereof is calculated as 1.0 kJ/(kg·K). In addition, prior to the measurement of thermal conductivity, the thermal conductivity of a pure copper sample having the same shape is measured under the same conditions, and the result thereof is used as a reference to correct the measurement result.

When the planar shape to be evaluated is smaller than a circular shape having a diameter of 10 mm, evaluation may be performed by cutting out a plurality of samples and arranging them so that their surfaces lie on the same plane, thereby securing a measurement area of 50 mm² or more.

### <Method for Producing Metal Porous Body>

An example of the method for producing the metal porous body of the heat transfer system of Embodiment 1 will be described below. The method for producing the metal porous body of Embodiment 1 may include a preparation step, a mixing step, a sintering step, and a washing step.

### <<Preparation Step>>

In the preparation step, a raw material powder for the metal porous body and sodium chloride powder (NaCl powder) are prepared.

Examples of the raw material powder include a metal powder composed of a single metal element selected from a first group consisting of aluminum, magnesium, copper, silver, and gold; an alloy powder composed of two or more metal elements selected from the first group; and a powder composed of one or more metal elements selected from the first group and one or more elements selected from a second group consisting of iron, cobalt, chromium, nickel, manganese, tin, zinc, silicon, phosphorus, carbon, boron, scandium, molybdenum, tungsten, and titanium.

For the above-described raw material powder, the D10 of particle diameter is 6 to 45 µm, the D50 is 13 to 75 µm, and the D90 is 27 to 106 µm. Here, the D10 of particle diameter of the raw material powder refers to a particle diameter at which the cumulative volume fraction from a small diameter side reaches 10% in a histogram in which the horizontal axis represents particle diameter and the vertical axis represents volume fraction. The D50 of particle diameter of the raw material powder refers to a particle diameter at which the cumulative volume fraction from a small diameter side reaches 50% in the above-described histogram. The D90 of particle diameter of the raw material powder refers to a particle diameter at which the cumulative volume fraction from a small diameter side reaches 90% in the above-described histogram. The above-described D10, D50, and D90 are measured by a laser diffraction and scattering method.

The particle diameter D50 of the NaCl powder is 45 to 500 µm. Here, the particle diameter D50 of the NaCl powder refers to a particle diameter at which the cumulative volume fraction from a small diameter side reaches 50% in a histogram in which the horizontal axis represents particle diameter and the vertical axis represents volume fraction. Sieving is performed using the sieves specified in JIS Z 8801-1:2019 "Test sieves - Part 1: Test sieves of metal wire cloth", the mass of the sample remaining on each sieve is measured, and based on the results, the histogram is prepared.

### <<Mixing Step>>

Next, in the mixing step, the raw material powder and the NaCl powder are mixed to obtain a mixed powder. The mixing ratio of the raw material powder and the NaCl powder is adjusted as appropriate depending on the porosity of the metal porous body to be produced. The percentage of the NaCl powder in the mixed powder varies depending on the average particle diameter of the NaCl powder, and is set to 60 to 88% by volume when the particle diameter is 45 to 70 µm, and set to 79 to 88% by volume when the particle diameter is more than 70 µm and 500 µm or less.

The mixed powder is sealed in a cylindrical glass container with a diameter of 100 mm and a wall thickness of 1 mm, and mixed for 10 minutes by rotating the glass container about its axis at 120 rpm. For mixing, a rotary mill can be used, for example. Alternatively, as long as the raw material powder and the NaCl powder can be uniformly mixed, a W-type mixer, a V-type mixer, or a drum-type mixer may be used. When there is a risk of dust explosion of the mixed powder, the inside of the glass container may be replaced with a low oxygen atmosphere or an inert atmosphere.

### <<Sintering Step>>

Next, in the sintering step, the mixed powder is loaded into a mold made of graphite or hot work alloy tool steel, and pressure sintering is carried out to obtain a sintered material. The conditions for pressure sintering are 20 to 750°C, a pressure of 10 to 2000 MPa, and a holding time of 1 second to 30 minutes. Before pressure sintering, the mixed powder may be preliminarily shaped to form a compact.

### <<Washing Step>>

Next, in the washing step, the sintered material is immersed in water to elute NaCl into the water, thereby obtaining the metal porous body. Specifically, about 1 L of pure water is prepared for 10 g of the sintered material. Pure water is placed in a beaker, the sintered material is immersed in the pure water, and stirring is performed. By carrying out the immersion for a total of about 50 hours while replacing the pure water every 5 hours, NaCl is sufficiently eluted out from the metal porous body. As a result, the metal porous body of the heat transfer system of Embodiment 1 can be obtained.

### <Volume of Metal Porous Body>

In Embodiment 1, metal porous body 4 is provided in a heat receiving region 6, and the volume occupied by the metal porous body 4 with respect to the volume of heat receiving region 6 may be 30% or more. According to this, the amount of heat transferred from metal porous body 4 to fluid 2 increases, the flow velocity of the fluid further improves, the overall generated flow of the heat transfer system further improves, and heat exchange efficiency further improves.

The volume occupied by metal porous body 4 with respect to the volume of heat receiving region 6 may be 30% or more and 100% or less, may be 40% or more and 100% or less, may be 50% or more and 100% or less, or may be 90% or more and 100% or less.

### <Flow Passage Cross-Sectional Area Adjusting Member>

In the flow passage provided with metal porous body 4 of heat transfer system 1 of Embodiment 1, flow passage cross-sectional area adjusting member 12 is provided in a flow passage other than flow passage 3 provided with the metal porous body. There is no particular restriction on the shape of flow passage cross-sectional area adjusting member 12 as long as it is a shape capable of reducing the third cross-sectional area S3.

The material of flow passage cross-sectional area adjusting member 12 can be selected as appropriate in consideration of resistance to the fluid, thermal conductivity, heat insulation, and other factors. For example, a fluororesin such as polytetrafluoroethylene, stainless steel, copper, aluminum, or the like can be used.

Flow passage wall 3a and flow passage cross-sectional area adjusting member 12 may be in contact with each other. Flow passage wall 3a and flow passage cross-sectional area adjusting member 12 may be integrally formed or may be joined by soldering. Alternatively, flow passage wall 3a and flow passage cross-sectional area adjusting member 12 may not be in contact with each other. Examples of such a configuration include cases where another member is interposed between flow passage wall 3a and flow passage cross-sectional area adjusting member 12.

### <Fluid>

In heat transfer system 1 of Embodiment 1, fluid 2 may be a liquid. There is no particular restriction on fluid 2 as long as it is a type generally used in heat transfer systems. Examples of fluid 2 include water, radiator fluid, acetone, ethanol, and industrial water. In particular, when the fluid is industrial water or the like containing impurities, in conventional heat transfer systems, the heat exchange efficiency tended to decrease associated with use. According to the heat transfer system of the present disclosure, even when the fluid is industrial water or the like containing impurities, a decrease in heat exchange efficiency associated with use is suppressed.

There is no particular restriction on the viscosity of fluid 2 as long as it is within a range generally used in transfer systems. For example, the viscosity of fluid 2 may be 0.1 mPa·s or more and 10 mPa·s or less.

The heat transfer system 1 may further include a pump 5 that circulates fluid 2 in a predetermined flow direction.

### <Heat Source>

Heat transfer system 1 of Embodiment 1 can further include heat source 8 provided outside flow passage 3, which supplies heat to fluid 2. There is no particular limitation on the heating means of heat source 8. For example, a direct heat source such as a semiconductor device, an electric heater, an air heater, or a lamp heater, solar light, waste heat recovered from an engine or a heat treatment furnace, or the like can be used.

### [Embodiment 2]

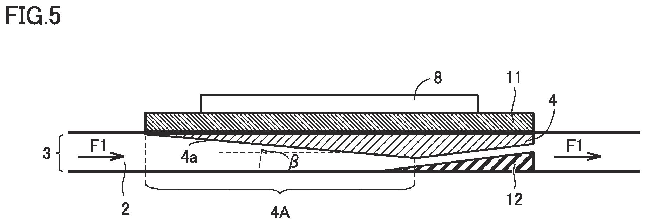

A heat transfer system in another embodiment of the present disclosure (hereinafter, also referred to as "Embodiment 2") will be described. The heat transfer system of Embodiment 2 may have the same configuration as that of the heat transfer system of Embodiment 1, except for the shape of the metal porous body. Hereinafter, the shape of the metal porous body will be described with reference to Fig. 2, Fig. 3, and Fig. 5. Fig. 2 is a diagram showing a region provided with a metal porous body 4 of a heat transfer system 1 of Embodiment 2, as viewed from above a heat source 8. Fig. 3 is a cross-sectional view taken along line III-III in Fig. 2. Fig. 5 is a cross-sectional view taken along line IV-IV in Fig. 2. In Fig. 5, a direction of the arrow F1 corresponds to the first direction from the upstream side to the downstream side of the flow passage.

In the heat transfer system of Embodiment 2, of the outer peripheral surface of metal porous body 4 in a second cross-sectional area increasing region 4A where the second cross-sectional area S2 of metal porous body 4 increases, an angle β formed between the normal direction of a surface that contacts the fluid existing outside metal porous body 4 (hereinafter, also referred to as "first contact surface 4a") and the first direction is 60° or more and less than 90°.

In the heat transfer system of Embodiment 2, the flow velocity of the fluid increases in the vicinity of the first contact surface 4a. When the flow velocity of the fluid increases, a force directed toward the outside of the metal porous body is applied to the fluid that has entered pores in the metal porous body, and the fluid is likely to move to the outside of the metal porous body. With movement of the fluid, impurities contained in the fluid also move to the outside of the metal porous body, and therefore, adhesion of impurities to the pores in the metal porous body is suppressed, and clogging of the metal porous body is suppressed. Thus, in the heat transfer system of Embodiment 2, heat exchange efficiency associated with use is suppressed.

Of all the outer peripheral surfaces of metal porous body 4, the percentage of the area of first contact surface 4a to the area of a surface that contacts the fluid existing outside metal porous body 4 (hereinafter, also referred to as "second contact surface") may be 30% or more, may be 50% or more, or may be 100%.

Of all the outer peripheral surfaces of metal porous body 4, the percentage of the area of first contact surface 4a to the area of the second contact surface, which contacts the fluid existing outside metal porous body 4, may be 80% or more, may be 90% or more, or may be 100%.

### [Embodiment 3]

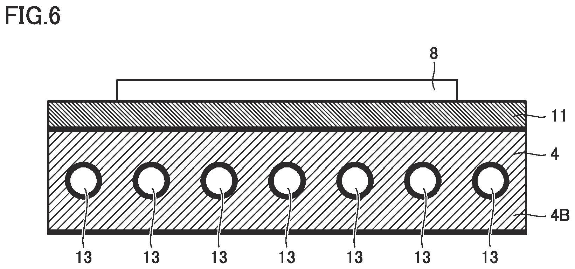

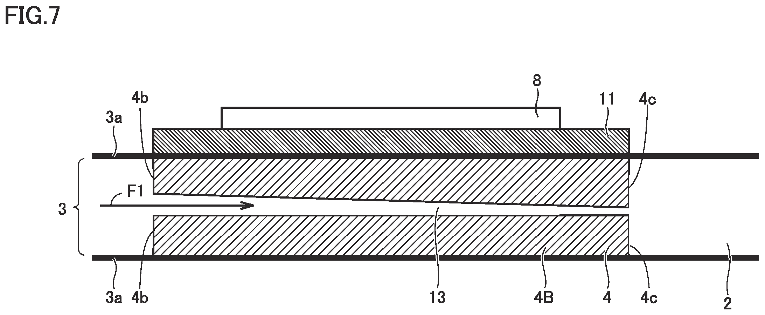

A heat transfer system in another embodiment of the present disclosure (hereinafter, also referred to as "Embodiment 3") will be described with reference to Fig. 2, Fig. 6, and Fig. 7. Fig. 2 is a diagram showing a region provided with metal porous body 4 of heat transfer system 1 of Embodiment 3, as viewed from above heat source 8. Fig. 6 is a cross-sectional view taken along line III-III in Fig. 2. Fig. 7 is a cross-sectional view taken along line IV-IV in Fig. 2. In Fig. 7, a direction of the arrow F1 corresponds to the first direction from the upstream side to the downstream side of the flow passage.

As shown in Fig. 7, metal porous body 4 includes a main body portion 4B extending along the first direction, a first end face 4b on the upstream side of the flow passage in main body portion 4B, and a second end face 4c on the downstream side of the flow passage in main body portion 4B. **In** metal porous body 4, a through-hole 13 penetrating from first end face 4b to second end face 4c is formed separately from the plurality of pores. That is, through-hole 13 is defined by the inner wall of metal porous body 4. The hole diameter of through-hole 13 in a cross-section of metal porous body 4 perpendicular to the first direction is sufficiently larger than the pore diameter in metal porous body 4 and is sufficiently larger than the size of impurities contained in the fluid.

**In** a cross-section of metal porous body 4 perpendicular to the first direction, when the cross-sectional area of through-hole 13 is defined as a fourth cross-sectional area S4, the metal porous body may include a region in which the fourth cross-sectional area S4 decreases along the first direction. According to this, in the region in which the cross-sectional area of the through-hole decreases, the flow velocity of the fluid increases. When the flow velocity of the fluid increases, a force directed toward the outside of the metal porous body is applied to the fluid that has entered pores in the metal porous body, and the fluid is likely to move to the outside of the metal porous body. With movement of the fluid, impurities contained in the fluid also move to the outside of the metal porous body, and therefore, adhesion of impurities to the pores in the metal porous body is suppressed, and clogging of the metal porous body is suppressed. Thus, in the heat transfer system of Embodiment 3, heat exchange efficiency associated with use is suppressed.

**In** a cross-section of flow passage 3 provided with metal porous body 4 of heat transfer system 1 of Embodiment 3 and perpendicular to the first direction, all outer edges of metal porous body 4 may be in contact with the flow passage wall. **In** this case, the cross-sectional area of through-hole 13 in a cross-section perpendicular to the first direction corresponds to the third cross-sectional area S3. Alternatively, in a cross-section of flow passage 3 provided with metal porous body 4 of heat transfer system 1 and perpendicular to the first direction, a part of the outer edge of metal porous body 4 may be in contact with flow passage wall 3a. **In** this case, the total of the cross-sectional area of through-hole 13 in a cross-section perpendicular to the first direction and the cross-sectional area of a region of flow passage 3 outside the outer edge of metal porous body 4 corresponds to the third cross-sectional area S3. The above-described cross-sectional area of through-hole 13 means, when there are a plurality of through-holes 13, the total of a plurality of cross-sectional areas.

The cross-sectional area of the through-hole in a cross-section perpendicular to the first direction may be 0.01 mm² or more and 100 mm² or less, or may be 0.015 mm² or more and 60 mm² or less.

The percentage of the minimum value to the maximum value of the cross-sectional area of the through-hole in a cross-section perpendicular to the first direction may be 1% or more and 50% or less.

In Fig. 6, the number of through-holes is seven, but the number of through-holes is not limited thereto. The number of through-holes may be one, or two or more.

The heat transfer system of Embodiment 3 may have the same configuration as that of the heat transfer system of Embodiment 1, except for the above. The heat transfer system of Embodiment 3 may include a flow passage cross-sectional area adjusting member, or may not include it.

### [Embodiment 4]

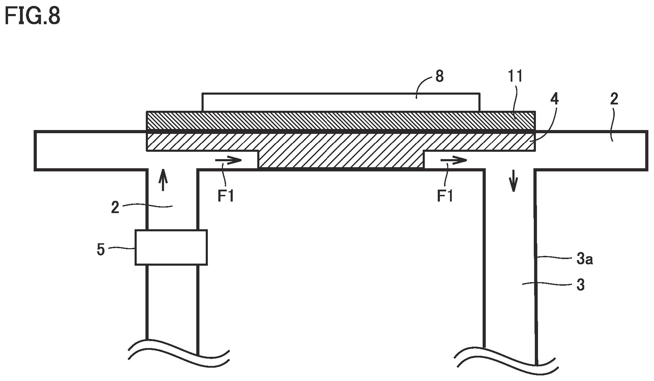

The configuration of a heat transfer system in another embodiment of the present disclosure (hereinafter, also referred to as "Embodiment 4") will be described with reference to Fig. 8 to Fig. 13. As shown in Fig. 8, heat transfer system 1 of Embodiment 4 includes flow passage wall 3a defining flow passage 3 through which fluid 2 flows, and metal porous body 4 that is disposed in flow passage 3 and transfers heat generated in heat source 8 to fluid 2 flowing through flow passage 3.

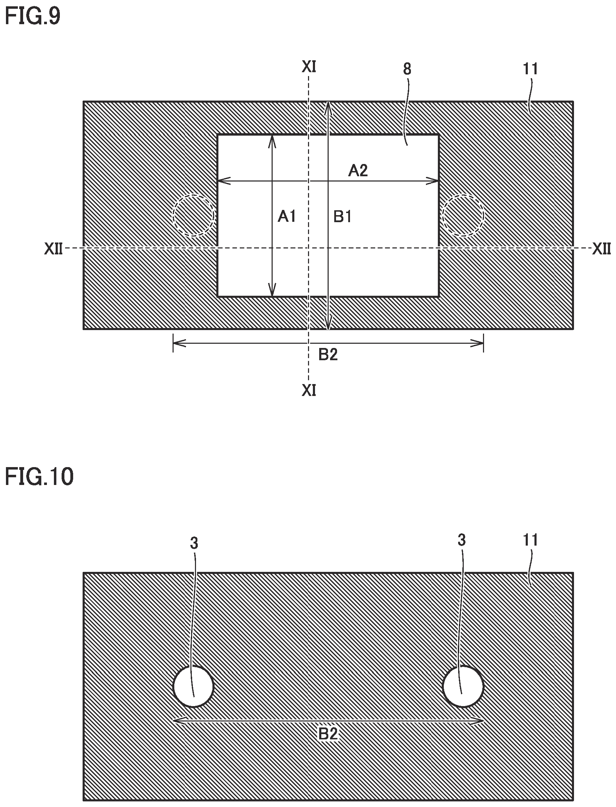

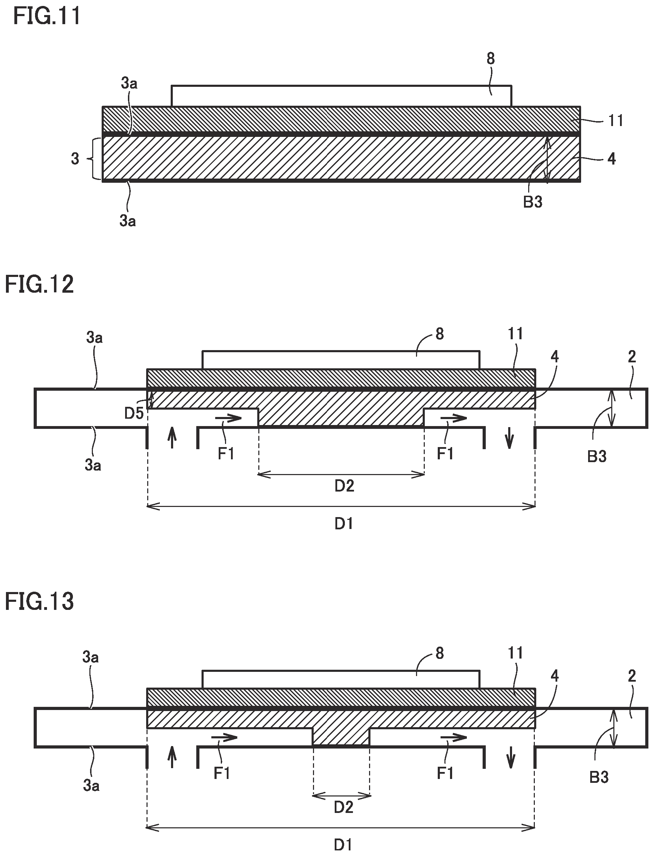

Fig. 9 is a diagram showing a region provided with metal porous body 4 of heat transfer system 1 of Fig. 8, as viewed from above heat source 8. Fig. 10 is a diagram showing Fig. 9 as viewed from a rear side. Fig. 11 is a cross-sectional view taken along line XI-XI in Fig. 9. Fig. 12 is an example of a cross-sectional view taken along line XII-XII in Fig. 9. Fig. 13 is another example of the cross-sectional view taken along line XII-XII in Fig. 9. In Fig. 12 and Fig. 13, a direction of the arrow F1 corresponds to the first direction from the upstream side to the downstream side of the flow passage.

Heat transfer system 1 of Embodiment 4 includes flow passage wall 3a defining flow passage 3 through which fluid 2 flows, and metal porous body 4 that is disposed in flow passage 3 and transfers heat generated in heat source 8 to fluid 2 flowing through flow passage 3. When viewed along the first direction from the upstream side to the downstream side of flow passage 3 provided with metal porous body 4, the metal porous body includes a first region having a first width D1 and positioned on a heat source side, and a second region that is provided on a side opposite to the heat source with the first region interposed therebetween and has a width narrower than the first width (hereinafter, also referred to as "second width D2"). As shown in Fig. 11, when flow passage 3 is viewed from the upstream side along the first direction, flow passage 3 is occupied by the first region and the second region. According to this, the pressure loss of fluid 2 when passing through the second region is smaller than the pressure loss of fluid 2 when passing through the first region, and the flow velocity of fluid 2 passing through the second region is higher than the flow velocity of fluid 2 passing through the first region. When the flow velocity of fluid 2 passing through the second region is higher than the flow velocity of the fluid passing through the first region, a force directed toward the outside of metal porous body 4 is applied to fluid 2 that has entered pores in the first region, and fluid 2 is likely to move to the outside of the metal porous body. With movement of fluid 2, impurities contained in fluid 2 also move to the outside of metal porous body 4, and therefore, adhesion of impurities to the pores in metal porous body 4 is suppressed, and clogging of metal porous body 4 is suppressed. Thus, in the heat transfer system of Embodiment 4, heat exchange efficiency associated with use is suppressed.

The percentage of the second width D2 (mm) of the second region to the first width D1 (mm) of the first region of metal porous body 4, (D2/D1) × 100, may be 20% or more and less than 100%.

The average pore diameter and porosity of the pores in the second region of metal porous body 4 may be the same as the average pore diameter and porosity of the pores in the first region. In this case, the percentage of the second width D2 (mm) of the second region to the first width D1 (mm) of the first region, (D2/D1) × 100, may be 20% or more and less than 100%.

The average pore diameter and porosity of the pores in the second region of metal porous body 4 may be larger than the average pore diameter and porosity of the pores in the first region. According to this, the pressure loss of the fluid when passing through the second region is further reduced, and the flow velocity of the fluid passing through the second region becomes faster. In addition, clogging by impurities is suppressed.

When the average pore diameter and porosity of the pores in the second region are larger than the average pore diameter and porosity of the pores in the first region, the percentage of the second width D2 (mm) of the second region to the first width D1 (mm) of the first region, (D2/D1) × 100, may be 30% or more and less than 100%.

The average pore diameter of the pores in the first region and the average pore diameter of the pores in the second region are measured by the mercury intrusion method described in Embodiment 1.

The heat transfer system of Embodiment 4 may have the same configuration as that of the heat transfer system of Embodiment 1, except for the shape of the metal porous body described above. The heat transfer system of Embodiment 4 may include a flow passage cross-sectional area adjusting member, or may not include it.

### EXAMPLES

The present embodiments will be described even further specifically by way of Examples. However, the present embodiments will not be limited by these Examples.

### [Study 1]

### <Fabrication of Heat Transfer System>

Heat transfer system 1 having the configuration shown in Fig. 1 was fabricated, and the relationship between the structure inside flow passage 3 heated by heat source 8 and heat transfer efficiency was confirmed. In all samples, structures other than the structure inside flow passage 3 heated by heat source 8 were the same.

Flow passage 3 heated by heat source 8 has a rectangular shape, when viewed from above heat source 8, in which the length along the first direction of the flow passage (the length indicated by B2 in Fig. 2) is 80 mm and the length along the direction orthogonal to the first direction (the length indicated by B1 in Fig. 2) is 80 mm. When flow passage 3 is viewed from the upstream side, the length of flow passage 3 along the direction orthogonal to the first direction (the length indicated by B3 in Fig. 3) is 10 mm. The material of flow passage wall 3a is polytetrafluoroethylene. A cross-section perpendicular to the first direction of a flow passage upstream of flow passage 3 heated by heat source 8 (hereinafter, also referred to as "upstream side flow passage 3c") and a cross-section perpendicular to the first direction of a flow passage downstream of the flow passage heated by the heating section (hereinafter, also referred to as "downstream side flow passage 3d") are each elliptical with a major axis of 10 mm and a minor axis of 8 mm.

Metal plate 11 made of aluminum was disposed between heat source 8 and flow passage wall 3a. The principal face of metal plate 11 has a rectangular shape of 80 mm × 80 mm and is disposed so as to cover an outer wall of flow passage wall 3a on a heat source 8 side. The size of the surface of heat source 8 in contact with metal plate 11 has a rectangular shape of 60 mm × 60 mm.

### <<Sample 1-1 to Sample 1-3>>

In the heat transfer systems of Sample 1-1 to Sample 1-3, the structure inside flow passage 3 was configured to have the structure shown in Fig. 3 to Fig. 4. The metal porous body is sheet-shaped, has a rectangular principal face with a size of 80 mm × 80 mm, and has a thickness of 5 mm. The composition of the metal porous body is pure copper, the pore diameter of the pores is 15 µm to 250 µm, the porosity is 70%, and the permeability is 1 × 10⁻¹² m². The metal porous body and the flow passage wall were integrally formed.

On the downstream side of flow passage 3, flow passage cross-sectional area adjusting member 12 was provided on flow passage wall 3a on a side opposite to flow passage wall 3a provided with metal porous body 4 having flow passage 3 interposed therebetween. In a cross-section of each sample along the thickness direction of flow passage 3 and the first direction, an angle α formed between flow passage wall 3a and a surface of flow passage cross-sectional area adjusting member 12 on the upstream side (an angle α shown in Fig. 3) is shown in the column "Angle α (°)" of Table 1. The percentage of the length L3 of the region in which the third cross-sectional area S3 decreases along the first direction to the length L1 of the metal porous body along the first direction in each sample, (L3/L1) × 100, is shown in the column "L3/L1 (%)" of Table 1. The flow passages of the heat transfer systems of Sample 1-1 to Sample 1-3 include the region in which the third cross-sectional area S3 decreases.

### <<Sample 2>>

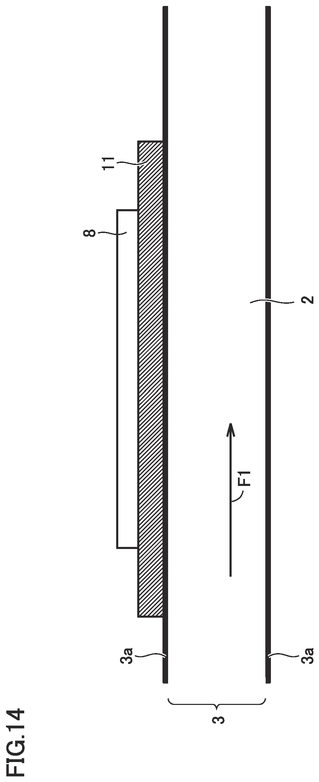

The heat transfer system of Sample 2 was configured to have the same structure as that of Sample 1 except that no metal porous body or flow passage cross-sectional area adjusting member was provided in the flow passage (see Fig. 14). The flow passage of the heat transfer system of Sample 2 does not include the region in which the third cross-sectional area S3 decreases.

### <<Sample 3>>

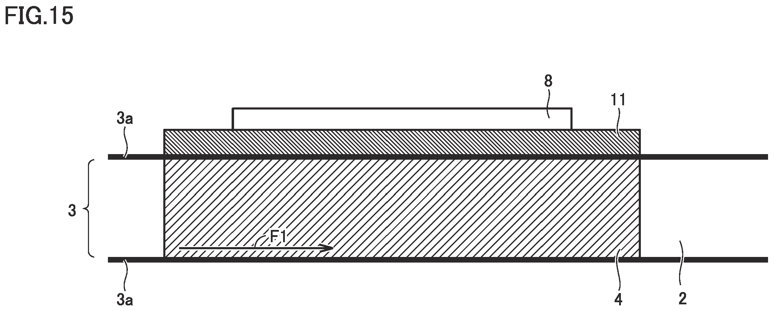

The heat transfer system of Sample 3 was configured to have the same structure as that of Sample 1 except that a metal porous body having a larger thickness than that of Sample 1 was used for occupying the flow passage, and that no flow passage cross-sectional area adjusting member was provided (see Fig. 15). The flow passage of the heat transfer system of Sample 3 does not include the region in which the third cross-sectional area S3 decreases.

### <<Sample 4>>

The heat transfer system of Sample 4 was configured to have the same structure as that of Sample 1 except that no flow passage cross-sectional area adjusting member was provided (see Fig. 16). The flow passage of the heat transfer system of Sample 4 does not include the region in which the third cross-sectional area S3 decreases.

### <<Sample 5>>

The heat transfer system of Sample 5 was configured to have the same structure as that of Sample 1 except for the shape of the metal porous body (see Fig. 5). The metal porous body of Sample 5 includes, on the upstream side of the flow passage, a region in which the cross-sectional area in a cross-section perpendicular to the first direction (corresponding to the second cross-sectional area S2) increases. The flow passage of the heat transfer system of Sample 5 includes the region in which the third cross-sectional area S3 decreases.

### <<Sample 6>>

The heat transfer system of Sample 6 was configured to have the same structure as that of Sample 1 except that the angle α of the flow passage cross-sectional area adjusting member is 45° (see Fig. 4). The flow passage of the heat transfer system of Sample 6 includes the region in which the third cross-sectional area S3 decreases.

### <Heat Exchange Efficiency Evaluation Test for Heat Transfer System>

Using industrial water having an alkalinity of 400 mg/L as fluid 2, a heat exchange efficiency evaluation test for the heat transfer system of each sample was carried out. The total alkalinity was determined by the Gran's plot method (Japanese Journal of JSCE, No. 685/VII-20, (2001), 157-164).

While applying a driving force to fluid 2 by pump 5, heat source 8 was operated to supply heat to fluid 2, thereby driving heat transfer system 1 of each sample. The flow rate of fluid 2 when flowing into flow passage 3 heated by heat source 8 was 0.15 L/min. In the heat transfer system of each sample, the electric power of heat source 8 was set to 2 W, and a temperature T1 of metal plate 11 after 1 hour had elapsed from the start of heating and a temperature T2 of metal plate 11 after 100 hours had elapsed were measured using a thermocouple. For each sample, the percentage of the difference between T2 and T1 to T1 (hereinafter, also referred to as "rate of change"), {(T2 - T1)/T1} × 100, was calculated. The results are shown in the column "Rate of change (%)" of Table 1. When T2 is 53°C or lower and the rate of change is 10% or less, it is determined that the heat transfer system has excellent heat exchange efficiency and that a decrease in heat exchange efficiency associated with use is suppressed.

### [Table 1]

**Table 1**

| | L3/L1 | Heat exchange efficiency evaluation test | | | Flow passage cross-sectional area adjusting member |
|---|---|---|---|---|---|
| | (%) | T1 | T2 | Rate of change (%) | Angle α (°) |
| Sample 1-1 | 30 | 45 | 46 | 2 | 15 |
| Sample 1-2 | 20 | 52 | 53 | 2 | 30 |
| Sample 1-3 | 100 | 46 | 49 | 7 | 5 |
| Sample 2 | - | 58 | 59 | 2 | - |
| Sample 3 | - | 43 | 60 | 40 | - |
| Sample 4 | - | 47 | 57 | 21 | - |
| Sample 5 | 30 | 44 | 46 | 5 | 15 |
| Sample 6 | 55 | 43 | 47 | 9 | 45 |

### [Discussion]

The heat transfer systems of Sample 1-1 to Sample 1-3, Sample 5, and Sample 6 correspond to Examples. These heat transfer systems have T2 of 53°C or lower and a rate of change of 10% or less, and thus have excellent heat exchange efficiency and suppress a decrease in heat exchange efficiency associated with use.

The heat transfer system of Sample 2 corresponds to Comparative Example. The heat transfer system of Sample 2 has T2 of 59°C and exhibited inferior heat exchange efficiency.

The heat transfer systems of Sample 3 and Sample 4 correspond to Comparative Examples. The heat transfer systems of Sample 3 and Sample 4 have T2 of higher than 53°C and a rate of change of more than 10%, and thus exhibited inferior heat exchange efficiency, and also experienced a decrease in heat exchange efficiency associated with use.

### [Study 2]

### <Fabrication of Heat Transfer System>

Heat transfer system 1 having the configuration shown in Fig. 8 was fabricated, and the relationship between the structure inside flow passage 3 heated by heat source 8 and heat transfer efficiency was confirmed. In all samples, structures other than the structure inside flow passage 3 heated by heat source 8 were the same.

Flow passage 3 heated by heat source 8 has a rectangular shape, when viewed from above heat source 8, in which the length along the first direction of the flow passage (the length indicated by B2 in Fig. 9) is 80 mm and the length along the direction orthogonal to the first direction (the length indicated by B1 in Fig. 9) is 80 mm. When flow passage 3 is viewed from the upstream side, the length of flow passage 3 along the direction orthogonal to the first direction (the length indicated by B3 in Fig. 12) is 10 mm. The material of flow passage wall 3a is polytetrafluoroethylene.

Metal plate 11 made of aluminum was disposed between heat source 8 and flow passage wall 3a. The principal face of metal plate 11 has a rectangular shape of 80 mm × 80 mm and is disposed so as to cover an outer wall of flow passage wall 3a on a heat source 8 side. The size of the surface of heat source 8 in contact with metal plate 11 has a rectangular shape of 60 mm × 60 mm.

### <<Sample 2-1>>

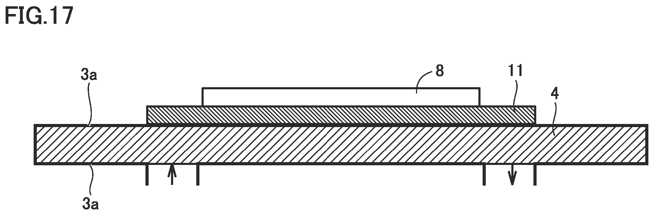

In the heat transfer system of Sample 2-1, the structure inside the flow passage was configured to have the structure shown in Fig. 17. The metal porous body is sheet-shaped, has a rectangular principal face with a size of 80 mm × 80 mm, and has a thickness of 10 mm. The composition of the metal porous body is pure copper, the pore diameter of the pores is 15 µm to 250 µm, the porosity is 70%, and the permeability is 1 × 10⁻¹² m². The metal porous body and the flow passage wall were integrally formed.

The metal porous body of Sample 2-1 does not include a first region having a first width and positioned on a heat source side, or a second region that is provided on a side opposite to the heat source with the first region interposed therebetween and has a width narrower than the first width.

### <<Sample 2-2 and Sample 2-3>>

The heat transfer systems of Sample 2-2 and Sample 2-3 were configured to have the same configuration as that of Sample 2-1 except that the shape of the metal porous body had the shape shown in Fig. 12. Sample 2-2 and Sample 2-3 include a first region having a first width D1 and positioned on a heat source side, and a second region that is provided on a side opposite to the heat source with the first region interposed therebetween and has a second width D2 narrower than the first width. The first width D1, the second width D2, and the percentage (D2/D1) × 100 in the metal porous bodies of Sample 2-2 and Sample 2-3 are shown in Table 2. In Sample 2-2 and Sample 2-3, the thickness of a portion not corresponding to the second width D2 (the thickness indicated by D5 in Fig. 12) is 5 mm.

### <Heat Exchange Efficiency Evaluation Test for Heat Transfer System>

A heat exchange efficiency evaluation test for the heat transfer system of each sample was carried out. The specific test method and evaluation criteria are the same as those of Study 1. The results are shown in Table 2.

### [Table 2]

**Table 2**

| | D1 | D2 | (D2/D1) × 100 | Heat exchange efficiency evaluation test | | |
|---|---|---|---|---|---|---|
| | mm | mm | % | T1 | T2 | Rate of change (%) |
| Sample 2-1 | 80 | - | - | 42 | 56 | 33 |
| Sample 2-2 | 80 | 32 | 40 | 44 | 46 | 5 |
| Sample 2-3 | 80 | 20 | 25 | 46 | 47 | 2 |

### [Discussion]

The heat transfer system of Sample 2-1 corresponds to Comparative Example. The heat transfer system of Sample 2-1 has T2 of higher than 53°C and a rate of change of more than 10%, and thus exhibited inferior heat exchange efficiency, and also experienced a decrease in heat exchange efficiency associated with use.

The heat transfer systems of Sample 2-2 and Sample 2-3 correspond to Examples. The heat transfer systems of Sample 2-2 and Sample 2-3 have T2 of 53°C or lower and a rate of change of 10% or less, and thus have excellent heat exchange efficiency and suppress a decrease in heat exchange efficiency associated with use.

Although the embodiments and Examples of the present disclosure have been described above, it has been planned from the beginning that the configurations of the embodiments and Examples described above may be combined as appropriate or modified in various ways.

It should be understood that the embodiments and Examples disclosed herein are illustrative in all respects and are not restrictive. The scope of the present invention is defined not by the above-described embodiments and Examples but by the claims, and is intended to include meanings equivalent to the claims and all modifications within the scope.

### REFERENCE SIGNS LIST

1 Heat transfer system; 2 Fluid; 3 Flow passage; 3a Flow passage wall; 3c Upstream side flow passage; 3d Downstream side flow passage; 4 Metal porous body; 4A Second cross-sectional area increasing region; 4B Main body portion; 4a First contact surface; 4b First end face; 4c Second end face; 5 Pump; 6 Heat receiving region; 8 Heat source; 11 Metal plate; 12 Flow passage cross-sectional area adjusting member; 13 Through-hole.

## Claims

1. A heat transfer system for transferring heat generated in a heat source by using a fluid, the heat transfer system comprising:
a flow passage wall defining a flow passage through which the fluid flows; and
a metal porous body that is disposed in the flow passage and transfers heat generated in the heat source to the fluid flowing through the flow passage,
wherein, in a cross-section of the flow passage perpendicular to a first direction from an upstream side to a downstream side in the flow passage provided with the metal porous body, when a cross-sectional area of the flow passage is defined as a first cross-sectional area S1, a cross-sectional area of the metal porous body is defined as a second cross-sectional area S2, and an area S1 - S2 obtained by subtracting the second cross-sectional area S2 from the first cross-sectional area S1 is defined as a third cross-sectional area S3, the flow passage includes a region in which the third cross-sectional area S3 decreases along the first direction,
wherein the metal porous body is composed of a metal in which a plurality of pores are formed,
wherein at least some of the pores among the plurality of pores are open pores,
wherein the metal is composed of:
a metal composed of a single metal element selected from a first group consisting of aluminum, magnesium, copper, silver, and gold;
an alloy composed of two or more metal elements selected from the first group;
a metal in a composite state of two or more metal elements selected from the first group;
an alloy composed of one or more metal elements selected from the first group and one or more elements selected from a second group consisting of iron, cobalt, chromium, nickel, manganese, tin, zinc, silicon, phosphorus, carbon, boron, scandium, molybdenum, tungsten, and titanium; or
a metal in a composite state of one or more metal elements selected from the first group and one or more elements selected from the second group,
wherein a pore diameter of the pores in the metal porous body is 10 µm or more and 420 µm or less,
wherein a porosity of the metal porous body is 60% or more and 85% or less, and
wherein a permeability of the metal porous body is 0.6 × 10⁻¹² m² or more.

2. The heat transfer system according to claim 1, wherein a length L3 of the region in which the third cross-sectional area S3 decreases along the first direction is 30% or more of a length L1 of the metal porous body along the first direction.

3. The heat transfer system according to claim 1 or 2, wherein the flow passage wall includes a flow passage cross-sectional area adjusting member that is disposed in the flow passage and configured to decrease the third cross-sectional area S3.

4. The heat transfer system according to claim 1 or 2,
wherein the metal porous body includes a main body portion extending along the first direction, a first end face on an upstream side of the flow passage in the main body portion, and a second end face on a downstream side of the flow passage in the main body portion, and
wherein, in the metal porous body, a through-hole penetrating from the first end face to the second end face is formed separately from the plurality of pores.

5. The heat transfer system according to claim 4,
wherein, in a cross-section of the metal porous body perpendicular to the first direction, when a cross-sectional area of the through-hole is defined as a fourth cross-sectional area S4, the metal porous body includes a region in which the fourth cross-sectional area S4 decreases along the first direction, and
wherein, in a cross-section of the flow passage provided with the metal porous body and perpendicular to the first direction, all outer edges of the metal porous body are in contact with the flow passage wall.

6. The heat transfer system according to any one of claims 1 to 5,
wherein the metal porous body includes a main body portion extending along the first direction, a first end face on an upstream side of the flow passage in the main body portion, and a second end face on a downstream side of the flow passage in the main body portion, and
wherein the heat transfer system comprises a shielding member provided on the first end face.

7. The heat transfer system according to any one of claims 1 to 6, wherein a thermal conductivity of the metal is 100 W/m·K or more.

8. The heat transfer system according to any one of claims 1 to 7, wherein a permeability of the metal porous body is 0.8 × 10⁻¹² m² or more.

9. The heat transfer system according to any one of claims 1 to 8, wherein an open porosity of the pores in the metal porous body is 60% or more.

10. A heat transfer system for transferring heat generated in a heat source by using a fluid, the heat transfer system comprising:
a flow passage wall defining a flow passage through which the fluid flows; and
a metal porous body that is disposed in the flow passage and transfers heat generated in the heat source to the fluid flowing through the flow passage,
wherein, when viewed along a first direction from an upstream side to a downstream side of the flow passage provided with the metal porous body, the metal porous body includes a first region having a first width and positioned on a heat source side, and a second region that is provided on a side opposite to the heat source with the first region interposed therebetween and has a width narrower than the first width,
wherein the flow passage is occupied by the first region and the second region,
wherein the metal porous body is composed of a metal in which a plurality of pores are formed,
wherein at least some of the pores among the plurality of pores are open pores,
wherein the metal is composed of:
a metal composed of a single metal element selected from a first group consisting of aluminum, magnesium, copper, silver, and gold;
an alloy composed of two or more metal elements selected from the first group;
a metal in a composite state of two or more metal elements selected from the first group;
an alloy composed of one or more metal elements selected from the first group and one or more elements selected from a second group consisting of iron, cobalt, chromium, nickel, manganese, tin, zinc, silicon, phosphorus, carbon, boron, scandium, molybdenum, tungsten, and titanium; or
a metal in a composite state of one or more metal elements selected from the first group and one or more elements selected from the second group,
wherein a pore diameter of the pores in the metal porous body is 10 µm or more and 420 µm or less,
wherein a porosity of the metal porous body is 60% or more and 85% or less,
and
wherein a permeability of the metal porous body is 0.6 × 10⁻¹² m² or more.
